# EUROPEAN PATENT APPLICATION

(11) **EP 4 831 548 A1**
(43) Date of publication of application: **28.10.2026**
(21) Application number: 26173821.5
(22) Date of filing: 21.04.2026
(51) Int. Cl.: F24F 11/38, F24F 11/32, F24F 11/49, F24F 11/52, F24F 11/63, F24F 11/64, F24F 5/00, F24F 110/10, F24F 140/00, F24F 140/50, F24F 140/60, H05K 7/20

(54) **MODEL-BASED PREDICTIVE MONITORING AND DIAGNOSTICS FOR EVAPORATIVE FREE COOLING UNITS**

(30) Priority: 21.04.2025 US 202563791918 P; 27.01.2026 US 202619461173
(71) Applicant: Vertiv International GmbH, 8212 Neuhausen am Rheinfall (CH)
(72) Inventor: DALLA MANA, Giuseppe, 35010 Vigonza (IT); LIONELLO, Michele, 35127 PADOVA (IT)
(74) Representative: Bryn-Jacobsen, Caelia

(57) **Abstract**

A monitoring and diagnostic system of a cooling system may be provided including a monitor system including sensors sensing physical conditions of the system and an electrical power meter sensing an actual power consumption of the system; and a control system receiving data of the physical conditions and of the actual power consumption of the system; calculating an estimated power consumption of the system based on the data of the physical condition; comparing the estimated power consumption of the system to the actual power consumption of the system; determining whether a difference between the estimated power consumption of the system and the actual power consumption of the system is greater than a threshold; and outputting an alert based on whether the difference between the estimated power consumption of the system and the actual power consumption of the system is greater than the threshold.

## Description

### CROSS-REFERENCE TO RELATED APPLICATION(S)

This application claims the benefit of and priority to U.S. Provisional Application 63/791,918, filed on 21 April 2025, and U.S. Non-Provisional Application 19/461,173, filed on 27 January 2026.

### BACKGROUND

### 1. Field

Apparatuses and methods consistent with examples relate to a cooling system and to a monitoring and diagnostic system thereof.

### 2. Background

Cooling systems, such as direct expansion systems and evaporative free cooling (EFC) systems are often used in climate control applications, such as to cool data centers, industrial facilities, or large commercial buildings. Modem data centers use large numbers of computing systems and generate a significant amount of heat. Accordingly, cooling systems are utilized to remove excess heat from within many data centers. As one example, EFC systems leverage the principles of evaporative cooling and free cooling, in which cooler ambient temperatures are used to chill water or other fluids, bypassing the need for a traditional refrigeration cycle, to reduce energy consumption. An EFC system typically utilizes an outdoor unit that provides air cooling for a facility, utilizing a large, air-to-air heat exchanger along with evaporative free cooling technology.

In an example EFC unit, water may be sprayed or otherwise flow over a medium such as pads, plate air-to-air heat exchangers, or coils. An EFC is an indirect evaporative cooling unit, meaning that the fluid that is to be cooled, for example warm air from a data center, does not come into contact with the water which flows on an opposite side of the medium. When warm air, for example from the data center, passes across the dry sides of the medium, the water flowing on the opposite side evaporates, absorbing heat, and cooling the warm air, thereby providing the evaporative cooling. A free-cooling function may be provided when the outside ambient air is cooler than that of warm air to be cooled and is used as the cooling fluid and passed over the plates or other medium that forms channels in an air-to-air heat exchanger.

Ensuring continuous and efficient operation of cooling systems is paramount for data centers.

### SUMMARY

The examples may address at least the above such drawbacks and/or disadvantages and other disadvantages not described above. Also the examples are not required to overcome the disadvantages described above, and may not overcome any of the problems described above.

According to an example, an evaporative free cooling (EFC) combination system may comprise: an EFC system comprising: a heat exchanger, a first fan unit configured to direct return air into the heat exchanger and supply air out of the heat exchanger, and a second fan unit configured to direct ambient air into the heat exchanger and exhaust air out of the heat exchanger; a monitor system comprising: a sensor unit configured to sense a physical condition of the EFC system and an electrical power meter configured to sense an actual power consumption of the EFC system; and a control system, communicatively coupled to the monitor system, the control system comprising: a memory storing instructions thereon and a processor configured to execute the instructions and thereby: receive, from the monitor system, data of the physical condition and the actual power consumption of the EFC system; calculate an estimated power consumption of the EFC system based on the data of the physical condition; compare the estimated power consumption of the EFC system to the actual power consumption of the EFC system; determine whether a difference between the estimated power consumption of the EFC system and the actual power consumption of the EFC system is greater than a threshold; and output an alert based on whether the difference between the estimated power consumption of the EFC system and the actual power consumption of the EFC system is greater than the threshold.

According to an example, the sensor unit may comprise: a return air temperature sensor configured to sense a temperature of the return air directed into the heat exchanger; an ambient air temperature sensor configured to sense a temperature of the ambient air; a first fan sensor configured to sense a speed of the first fan unit; a second fan sensor configured to sense a speed of the second fan unit; and the data of the physical condition may comprise the temperature of the return air, the temperature of the ambient air, the speed of the first fan unit, and the speed of the second fan unit.

According to an example, the EFC system may further comprise an evaporative system comprising a pump configured to pump water from a water tank to a sprinkler unit configured to spray water onto the heat exchanger; the monitor system may further comprise a sensor configured to sense a pump status; and the data of the physical condition may further comprise the pump status.

According to an example, the EFC system may further comprise a direct expansion system comprising an evaporator and a compressor; the monitor system may further comprise at least one compressor sensor configured to sense a compressor status and a compressor speed; and the data of the physical condition may further comprise the compressor status and the compressor speed.

According to an example, the EFC combination system may further comprise: a user interface comprising at least one of a display unit and a speaker; wherein the processor of the control system may be configured to control the user interface to output one of a visual display and an alert sound.

According to an example, a monitoring and diagnostic system of an evaporative free cooling (EFC) system may comprise: a monitor system comprising: a sensor unit configured to sense a physical condition of the EFC system and an electrical power meter configured to sense an actual power consumption of the EFC system; and a control system, communicatively coupled to the monitor system, the control system comprising a memory storing instructions thereon and a processor configured to execute the instructions and thereby: receive, from the monitor system, data of the physical condition and the actual power consumption of the EFC system; calculate an estimated power consumption of the EFC system based on the data of the physical condition; compare the estimated power consumption of the EFC system to the actual power consumption of the EFC system; determine whether a difference between the estimated power consumption of the EFC system and the actual power consumption of the EFC system is greater than a threshold; and output an alert based on whether the difference between the estimated power consumption of the EFC system and the actual power consumption of the EFC system is greater than the threshold.

According to an example, the sensor unit may comprise: a return air temperature sensor configured to sense a temperature of return air directed into a heat exchanger of the EFC system; an ambient air temperature sensor configured to sense a temperature of ambient air; a first fan sensor configured to sense a speed of a first fan unit of the EFC system; and a second fan sensor configured to sense a speed of a second fan unit of the EFC system; and the data of the physical condition may comprise the temperature of the return air, the temperature of the ambient air, the speed of the first fan unit, and the speed of the second fan unit.

According to an example, the sensor unit may further comprise a sensor configured to sense a status of a pump pumping water from a water tank to a sprinkler unit of the EFC system; and the data of the physical condition may further comprise the pump status.

According to an example, the sensor unit may further comprise a compressor sensor configured to sense a compressor status and a compressor speed of a compressor of the EFC system; and the data of the physical condition may further comprise the compressor status and the compressor speed.

According to an example, the monitoring and diagnostic system may further comprise: a user interface comprising at least one of a display unit and a speaker; wherein the processor of the control system may be configured to control the user interface to output one of a visual display and an alert sound.

### BRIEF DESCRIPTION OF THE DRAWINGS

The above and other objects, advantages, and salient features will become apparent to those skilled in the art from the following detailed description of examples when taken in conjunction with the accompanying drawings in which:
FIGs. 1a and 1b are schematic illustrations of cooling systems according to one or more examples;
FIGs. 2a, 2b, and 2c are schematic illustrations of cooling systems identifying example locations of components of a monitor system according to an example;
FIG. 3 is a schematic illustration of a control system communicatively coupled to a monitor system and an output unit, according to an example;
FIG. 4 is a schematic illustration of a control system communicatively coupled to a monitor system and an output unit, according to another example;
FIG. 5 is a schematic illustration of a processing unit of a control system, according to an example; and
FIG. 6 is a flow chart of a monitoring method according to an example.

### DETAILED DESCRIPTION

Reference will now be made in detail to examples which are illustrated in the accompanying drawings, wherein like reference numerals refer to like elements throughout. In this regard, the examples may have different forms and may not be construed as being limited to the descriptions set forth herein.

It will be understood that the terms "include," "including", "comprise, and/or "comprising," when used in this specification, specify the presence of stated features, integers, steps, operations, elements, and/or components, but do not preclude the presence or addition of one or more other features, integers, steps, operations, elements, components, and/or groups thereof.

It will be further understood that, although the terms "first," "second," "third," and/or other, may be used herein to describe various elements, components, regions, layers and/or sections, these elements, components, regions, layers and/or sections may not be limited by these terms. These terms are only used to distinguish one element, component, region, layer or section from another element, component, region, layer or section.

As used herein, the term "and/or" includes any and all combinations of one or more of the associated listed items. Expressions such as "at least one of," when preceding a list of elements, modify the entire list of elements and do not modify the individual elements of the list.

Various terms are used to refer to particular system components. Different companies may refer to a component by different names - this document does not intend to distinguish between components that differ in name but not function.

Matters of these examples that are obvious to those of ordinary skill in the technical field to which these examples pertain may not be described here in detail.

As noted above, continuous and efficient cooling is paramount to the operation of data centers. According to one or more examples described herein, predictive monitoring and diagnostics may be utilized in data centers to detect potential anomalies in the operation of cooling systems with the aim of limiting downtime and inefficiencies. According to one or more examples a model-based predictive monitoring and diagnostic algorithm may be utilized, in conjunction with methods and systems described herein, to detect potential failures or abnormal operation of evaporative free cooling (EFC) systems.

One or more examples described herein may provide systems and methods which facilitate the detection and rectification of malfunctions in EFC systems at an early stage to thereby facilitate the prevention of imminent downtime or reduction of efficiency. According to one or more examples anomalous operating conditions may be detected by analyzing the power consumption of the EFC system with the aim of anticipating maintenance activities and reducing equipment downtime and efficiency losses due to malfunctions.

### Example Cooling systems

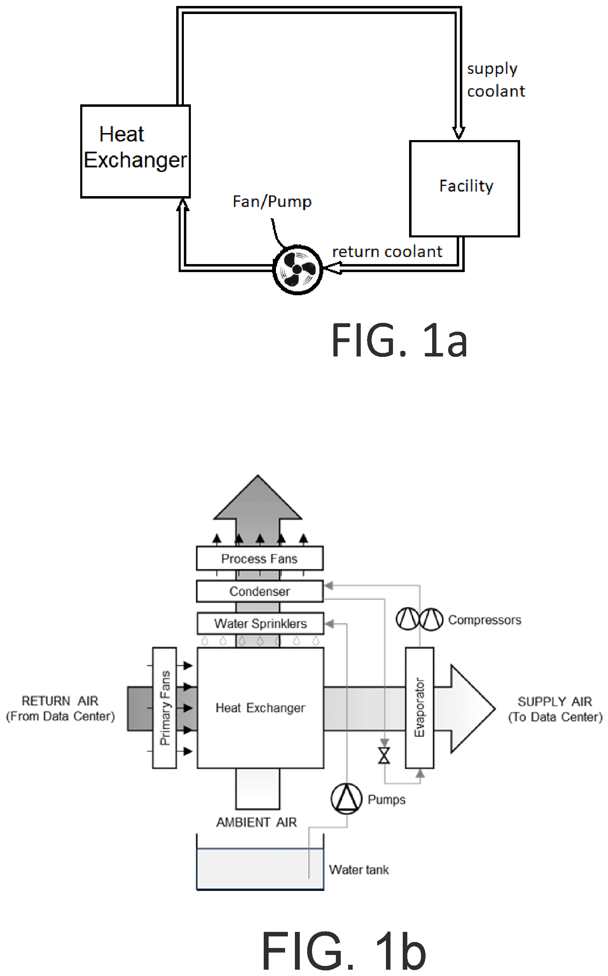

FIG., 1a is a schematic illustration of a cooling system including a heat exchanger, according to an example. The cooling system of FIG. 1a includes a heat exchanger which receives a warm or hot coolant from a unit or space to be cooled and outputs cooled supply coolant to the unit/space to be cooled. The system additionally includes one or more fan(s) or pump(s) which cycles the coolant through the heat exchanger. The cooling system of FIG. 1a may be incorporated into a larger system, for example, with the inclusion of an evaporator disposed in the circuit between the heat exchanger and the unit to be cooled, where the evaporator also part of a refrigeration circuit, such as a direct expansion (DX) system.

An EFC system is a type of cooling system, the purpose of which is to cool fluid (e.g. air), for example. Once the air or other fluid has been cooled, it is supplied back to a unit/space to be cooled, such as a datacenter or other facility, to ensure continuous operation. A properly functioning EFC cools the air or other fluid to a required temperature and supplies the cooled air/fluid back to the facility in a specific amount. The temperature difference between a the fluid exiting the facility and the cooled fluid reentering the facility, and its amount defines a requested cooling capacity of the EFC system.

FIG. 1b is a schematic illustration of an EFC system according to an example. The EFC system includes fans that direct air ("return air") from a data center and air ("ambient air") from the surrounding atmosphere through an air-to-air cross flow heat exchanger in which the ambient air absorbs heat from the return air. The fans include primary fans which direct the return air through the heat exchanger, and process fans which direct the ambient air through the heat exchanger. As shown, the primary fans may be positioned between the data center and an intake of the heat exchanger, and the process fans may be positioned at an output of the heat exchanger, but this is merely an example. The return air directed into the heat exchanger and the supply air output from the heat exchanger may be referred to herein, for example, as data center air, or as "first" air, in contrast to ambient air, which may also be referred to herein as "second" air.

The EFC system may also include an evaporative system that cools down the ambient air as it traverses the heat exchanger, thus increasing the capacity of the system to extract heat from the return air. The evaporative system may include, for example one or more pumps that move water from a tank to sprinklers that spray the water in channels of the heat exchanger in which the ambient air flows. The system may also include a direct expansion (DX) backup system including a refrigerant circuit that may include one or more fixed-speed and/or variable-speed compressors. The supply air output from the heat exchanger to the data center may additionally traverse through an evaporator of the refrigerant circuit of a DX backup system to thereby further cool the supply air.

As would be understood by one of skill in the art, for a data center, any interruption in cooling can lead to overheating servers thus causing interruptions in services and potential data loss. Additionally, data center cooling systems are key elements for energy efficiency improvement due to their high electrical power consumption. According to one or more examples, systems and methods utilizing predictive monitoring and diagnostics may be utilized in data centers with the aim of detecting potential anomalies in the operating conditions of cooling systems to thereby limit downtime and inefficiencies of the cooling components.

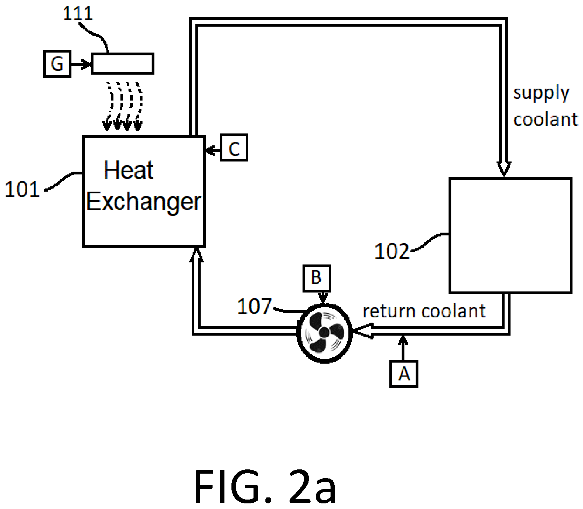

FIG. 2a illustrate a cooling system according to an example, including identification of example locations of components of a monitor system, according to one or more examples. As shown, analogously to the system described with respect to FIG. 1a, the system includes a heat exchanger 101 which receives a warm or hot coolant from a unit or space to be cooled 102 and outputs cooled supply coolant to the unit/space to be cooled. The system additionally includes one or more fan(s) or pump(s) 107 which cycles the coolant through the heat exchanger 101. The cooling system of FIG. 2a may be incorporated into a larger system, for example, with the inclusion of an evaporator disposed in the circuit between the heat exchanger 101 and the unit to be cooled 102, where the evaporator also part of a refrigeration circuit, such as a direct expansion (DX) system. As discussed in further detail below, a monitor system may include one or more sensors disposed at one or more example locations in the system of FIG. 2a, such as, but not limited to locations A, B, C, and G, as shown

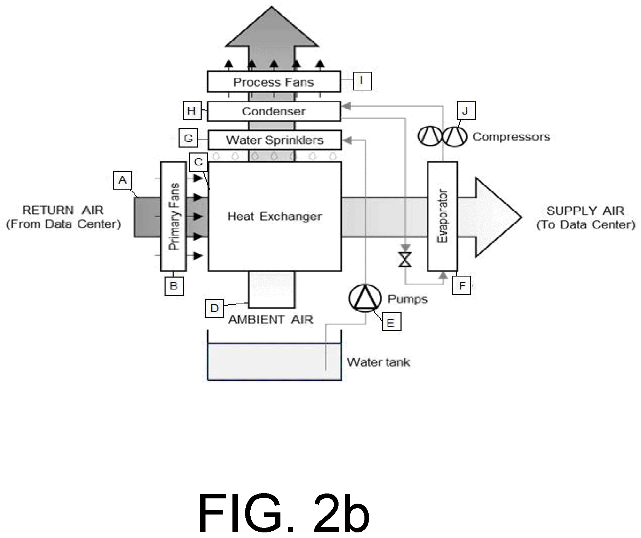

FIGs. 2a and 2b illustrate an EFC system according to an example, including identification of example locations of components of a monitor system, according to one or more examples. FIG. 2a illustrates a schematized layout of the EFC system 400, while FIG. 2b illustrates a flow diagram of the system 400. As shown, the system 400 includes a heat exchanger 401 which receives warm or hot return air from a data center 402 and outputs cooled supply air to the data center 402. One or more primary fans 407 direct the return air into the heat exchanger 401. Ambient air from the atmosphere also enter the heat exchanger 401. The evaporative system also includes one or more pumps 409 which pump water from a water tank 410 to one or more sprinklers 411 which spray or otherwise provide water to channels of the heat exchanger 401 though which air passes. The system 400 may additionally include a direct expansion system 450 which cycles refrigerant though a circuit including an evaporator 452, one or more compressors 451, a condenser 454, and an expansion valve 453. Supply air output from the heat exchanger 401 is direct to the evaporator 452 to further cool the supply air which is then directed to the data center 402.

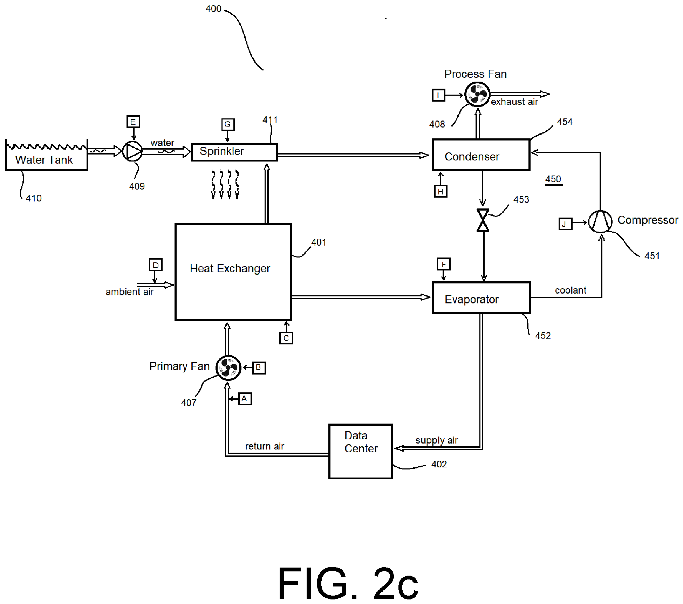

As discussed in further detail below, a monitor system 600 may include one or more sensors disposed at one or more example locations such as, but not limited to locations A, B, C, D, E, F, G, H, I, and J, illustrated in FIGs. 2b and 2c.

### Example predictive monitoring and diagnostic system

**Monitor system** - According to one or more examples, a predictive monitoring and diagnostic system may include a monitor system 600 configured to sense or otherwise obtain power consumption data from one or more components of a cooling system, for example a cooling system as described with respect to one of FIGs. 1a and 1b. Abnormal electrical power consumption is a symptom of degradation of the performance one or more components of a system. For example, degradation of a compressor or a fan causes an increase of the electrical power necessary to run the device. Also, fouling deposits may alter pressure drops and thermal performance of a heat exchanger , causing an increase in the electrical power necessary for the fan(s) and/or pump(s) to maintain the desired flow and heat transfer rate through the heat exchanger.

According to one example, a monitor system 600 includes one or more sensors configured to sense or otherwise obtain data from one or more locations and/or components within a cooling system. As shown in FIG. 2a, sensors may be positioned at locations of a cooling system including, but not limited to locations A, B, C, and G. Any one or more of the sensors may be communicatively coupled to one or more of the various components of the cooling system, as would be understood by one of skill in the art. As shown in FIGs. 2b and 2c, sensors may be positioned at locations of an EFC system including, but not limited to locations A-J, and one or more of the sensors may be communicatively coupled to one or more of the various components of the EFC system 400, as would be understood by one of skill in the art. For example, a monitor system 600 may include one or more temperature sensors sensing an inlet air temperature, for example of return air from a data center 102 or 402 at location A, B, or C; sensing an ambient air temperature, for example at location D; sensing an evaporating temperature, for example, at location F; and sensing a condensing temperature, for example at location H. Any one or more of the temperature sensors may be operatively coupled to any one or more of the components of a cooling system, as would be understood by one of skill in the art. The monitor system 600 may include one or more humidity sensors sensing an inlet air humidity, for example of the return air from a unit/space to be cooled, such as a data center, at location A, B, or C; and sensing an ambient air humidity, for example at location D. The monitor system 600 may include one or more sensors sensing the fan speed of any one or more of any fans and/or pumps within a cooling system, one or more sensors sensing the speed of a variable-speed compressor 451, one or more sensors sensing an operating status of one or more of the compressors 451, pumps 409, and water sprinklers 411, or any other element within a cooling system.

The sensor(s) of the monitor system 600 may be communicatively coupled to a control system 800 as discussed below, and may output data, for example, temperature, humidity, speed, or status data, to the control system 800. The sensor(s) may be configured to output current data continuously, or at a predetermined interval or at predetermined times, as would be understood by one of skill in the art.

According to another example, the monitor system 600 may include one or more energy meters operatively coupled to any one or more of the various components of a cooling system, and may thereby directly obtain a current electrical power consumption of any one or more of the various components and output data thereof to the control system. The energy meter(s) may be configured to output current data continuously, or at a predetermined interval or at predetermined times, as would be understood by one of skill in the art.

**Control system-** According to one or more examples, a predictive monitoring and diagnostic system may include a control system 800 configured to obtain information from the monitor system 600, and, based on the information, transmit output data, signal(s), notification(s), and/or alerts.

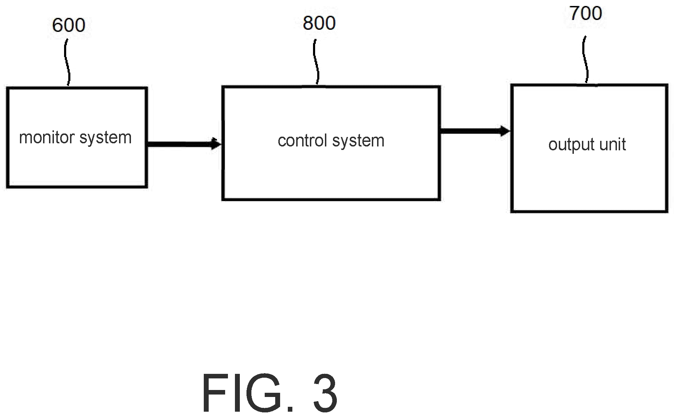

FIG. 3 is a schematic illustration of a control system 800 communicatively coupled to a monitor system 600 and an output unit 700, according to an example.

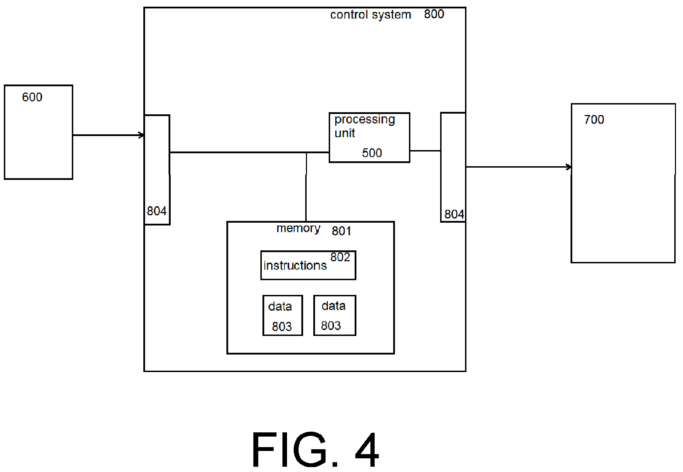

As shown in FIG. 4, a control system 800 may be a computer including a processing unit 500, a system memory 801, and a system bus (not shown). The system bus provides interconnections among the control system components. The processing unit 500 can be any of various available processors. Dual microprocessors and other multiprocessor architectures also can be employed as the processing unit 500.

The system bus can be any of several types of bus structures providing operative connections among the elements of the control system 800 including, but not limited to, a memory bus or memory controller, a peripheral bus or external bus, and/or a local bus using any of a variety of available bus architectures including, but not limited to, Industrial Standard Architecture (ISA), Micro-Channel Architecture (MSA), Extended ISA (EISA), Intelligent Drive Electronics (IDE), VESA Local Bus (VLB), Peripheral Component Interconnect (PCI), Card Bus, Universal Serial Bus (USB), Advanced Graphics Port (AGP), Personal Computer Memory Card International Association bus (PCMCIA), Firewire (IEEE 1394), and Small Computer Systems Interface (SCSI).

The system memory 801 may include volatile memory and nonvolatile memory. A basic input/output system (BIOS), containing basic routines to transfer information among elements of the control system 800, such as during start-up, may be stored in nonvolatile memory. By way of non-limiting example, nonvolatile memory may include read only memory (ROM), programmable ROM (PROM), electrically programmable ROM (EPROM), electrically erasable programmable ROM (EEPROM), flash memory, or nonvolatile random access memory (RAM) (e.g., ferroelectric RAM (FeRAM). Volatile memory may include random access memory (RAM), which may act as an external cache memory. By way of non-limiting example, RAM is available in many forms such as static RAM (SRAM), dynamic RAM (DRAM), synchronous DRAM (SDRAM), double data rate SDRAM (DDR SDRAM), enhanced SDRAM (ESDRAM), Synchlink DRAM (SLDRAM), direct Rambus RAM (DRRAM), direct Rambus dynamic RAM (DRDRAM), and Rambus dynamic RAM.

The control system 800 may also include removable and/or non-removable, volatile and/or non-volatile computer storage media, for example, a disk storage. A disk storage may include, but is not limited to, a magnetic disk drive, floppy disk drive, tape drive, Jaz drive, Zip drive, LS-100 drive, flash memory card, and a memory stick. Disk storage also may include storage media separately or in combination with other storage media including, but not limited to, an optical disk drive such as a compact disk ROM device (CD-ROM), CD recordable drive (CD-R Drive), CD rewritable drive (CD-RW Drive) or a digital versatile disk ROM drive (DVD-ROM). To facilitate connection of the disk storage devices to a system bus, a removable or non-removable interface may be used.

The control system can be implemented, at least in part, in digital electronic circuitry, analog electronic circuitry, or in computer hardware, firmware, software, or a combination thereof. Accordingly, the control system 800 may be implemented, at least in part as a computer program product such as a computer program, program code or computer instructions tangibly stored in the system memory 801 and executed by the processing unit 500. The control system may obtain information from the monitor system 600, via one or more input/output units 804. The information may be stored as data, for example in the memory 801 in the and, based on the information from the monitor system 600, the processing unit 500 may process and output data and/or control instructions, also via the one or more input/output units 804. The one or more input/output units 804 may be communicatively and operationally connected, either individually or in groups to one or more elements of the EFC system 400 and one or more elements of the monitor system 600, via wired or wireless connection. Of course, as would be understood by one of skill in the art, the control system 800 may alternately be implemented, for example, as a computer program product such as a computer program, program code or computer instructions tangibly embodied in another type of information carrier, or in a machine-readable storage device, for execution by, or to control the operation of, another type of data processing apparatus such as a programmable processor, a computer, multiple computers, or a programmable logic controller (PLC).

A computer program can be written in any form of programming language, including compiled or interpreted languages, and it can be deployed in any form, including as a stand-alone program or as a module, component, subroutine, or other unit suitable for use in a computing environment. A computer program can be deployed to be executed on one computer or other device or on multiple device at one site or distributed across multiple sites and interconnected by a communication network. Also, functional programs, codes, and code segments for accomplishing features described herein can be easily developed by programmers skilled in the art. Operations associated with the examples can be performed by one or more programmable processors executing a computer program, code or instructions to perform functions (e.g., by operating on input data and/or generating an output). Operations can also be performed by, and apparatuses described herein can be implemented as, special purpose logic circuitry, e.g., a field programmable gate array (FPGA) or an application-specific integrated circuit (ASIC), for example.

A general purpose processor may be a microprocessor, but in the alternative, the processor may be any conventional processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration.

Processors suitable for the execution of a computer program include, by way of example, both general and special purpose microprocessors, and any one or more processors of any kind of digital computer. Generally, a processor will receive instructions and data from a read-only memory or a random access memory or both. The essential elements of a computer are a processor for executing instructions and one or more memory devices for storing instructions and data. Generally, a computer will also include, or be operatively coupled to receive data from or transfer data to, or both, one or more mass storage devices for storing data, e.g., magnetic, magneto-optical disks, or optical disks. Information carriers suitable for embodying computer program instructions and data include all forms of non-volatile memory, including by way of example, semiconductor memory devices, e.g., electrically programmable read-only memory (ROM) (EPROM), electrically erasable programmable ROM (EEPROM), flash memory devices, and data storage disks (e.g., magnetic disks, internal hard disks, or removable disks, magneto-optical disks, and CD-ROM and DVD-ROM disks). The processor and the memory can be supplemented by, or incorporated in special purpose logic circuitry.

Computer-readable non-transitory media includes all types of computer readable media, including magnetic storage media, optical storage media, flash media and solid state storage media. It should be understood that software can be installed in and sold with a central processing unit (CPU) device. Alternately, software can be obtained and loaded into the CPU device, including obtaining the software through physical medium or distribution system, including, for example, from a server owned by the software creator or from a server not owned but used by the software creator. The software can be stored on a server for distribution over the Internet, for example.

Elements of the monitor system 600 may be communicatively and operationally connected, either individually or in groups of one or more elements of the monitor system 600 to one or more elements of the EFC system 400, for example to determine an operational status thereof. Such connections may be via wired or wireless connections either separately to individual elements or to groups of elements. Wireless connections may be, for example, via antennas, Bluetooth or Bluetooth Low Energy (BLE), Near-Field Communication (NFC), or another means, as would be understood by one of skill in the art. The control system 800 may be communicatively and operationally connected to the monitor system 600 via wired or wireless connections either to the monitor system as a whole, or separately to individual elements or groups of elements of the monitor system 600. Wireless connections may be, for example, via antennas, Bluetooth or Bluetooth Low Energy (BLE), Near-Field Communication (NFC), or another means, as would be understood by one of skill in the art. The control system 800 may also be communicatively and operationally connected to any one or more components, for example individual sensors, of the monitor system 600, via wired or wireless connections either to multiple components together, separately to each individual component, or separately to independent elements within a component. As with the connections to the monitor system 600, wireless connections to one or more individual components of the monitor system 600 may be, for example, via antennas, Bluetooth or Bluetooth Low Energy (BLE), Near-Field Communication (NFC), or another means, as would be understood by one of skill in the art.

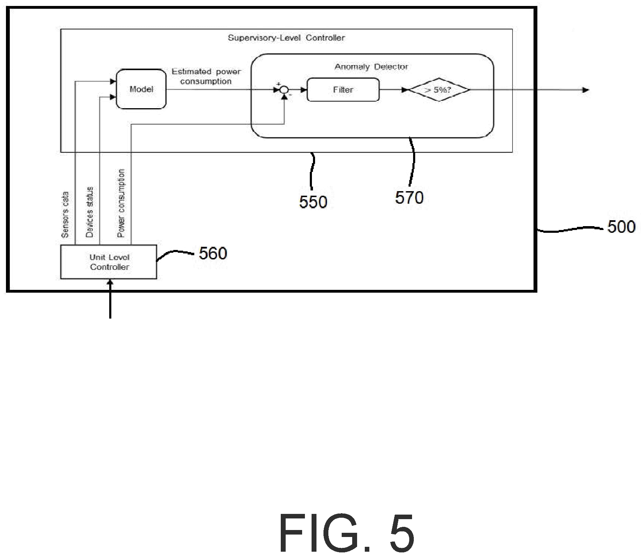

FIG. 5 is a schematic illustration of a processing unit 500 of a control system 800 according to an example. According to this example, the processing unit 500 may comprise a unit-level controller 560 which receives output(s) from the monitor system 600, and a supervisory-level controller 550 which receives sensor data and/or device status data, and/or power consumption information data from the unit-level controller 560 and transmits output data, signal(s), notification(s), and/or alerts. The supervisory level controller 550 may include: a model which determines an estimated power consumption of one or more components of the EFC system 400 based on received sensor data and/or status data; and an anomaly detector 570 which obtains a total power consumption as a sum of an estimated power consumption output from the model and the power consumption data output from the unit-level controller 560 and outputs data, signal(s), notification(s), and/or alerts.

According to one or more examples, a control system 800 may execute one or more of a monitoring algorithm and a diagnostic algorithm.

### Example operations

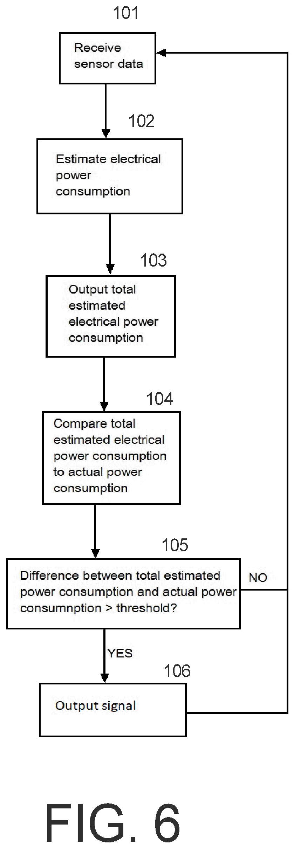

FIG. 6 is a flow chart of a monitoring method according to an example. The monitoring method may be executed by a control system 800 according to any example described herein, by means of a model algorithm, for example. According to an example a monitoring method may include receiving sensor data 101; estimating electrical power consumption 102; outputting a total estimated electrical power consumption 103; comparing the total estimated power consumption to an actual power consumption 104; determining whether a difference between the total estimated power consumption and the total actual power consumption is greater than a threshold 105; and outputting a signal 106.

According to one or more examples, the receiving sensor data 101 may include receiving output from any one or more of the sensors of the monitor system, for example, but not limited to: temperature in Celsius or Fahrenheit, humidity as a percentage, fan speed in a percentage of full speed or as revolutions per minute (rpm), and status as on, off, or a level. The receiving the sensor data may further include receiving an actual total power consumption of any one or more components of the EFC system and of the EFC system as a whole. Alternately, according to one or more examples, the receiving sensor data may include a first element of a controller, for example a unit-level controller, receiving the sensor data from one or more sensors and another element of the controller, for example, a model of a supervisory-level controller, receiving the sensor data from the first element of the controller.

The estimating electrical power consumption 102 may include obtaining one or more physical equations and characteristic curves from a memory. Each one or more of the physical equations and/or characteristic curves may be associated with one component of the EFC system and may represent a relationship between sensed data and an electrical power consumption of the component. For example, a physical equation obtained from a manufacturer of a process fan may represent a relationship between a speed of the fan and an electrical power consumption thereof. Another example physical equation or characteristic curve may represent a relationship among two or more of an inlet air temperature, an inlet air humidity, an ambient air temperature, an ambient air humidity, an evaporating temperature, and a condensing temperature, and an electrical power consumption of the heat exchanger. The estimating electrical power consumption 102 may further include estimating an electrical power consumption of one or more components of the EFC system based on the received sensor data and one or more physical equations and/or characteristic curves. The estimating electrical power consumption may further include summing the estimated power consumption of two or more components of the EFC system. For example, an electrical power of each fan may be calculated as a function of the fan speed and the air flow using a characteristic curve of the fan. The electrical power of compressors, for example, may be calculated using polynomials provided by the manufacturer. A total estimated electrical power consumption may be calculated, for example, in kilowatts (kW): *P_{TOT} = P_{fans} + Pₚᵤₘₚₛ* + *P_{compressors} + Pₐᵤₓ*

Thus, according to one or more examples, the monitor method, for example, a monitor algorithm thereof, may utilize a model-based approach. For example, a mathematical model is created to estimate the electrical power consumption of the cooling unit given the current operating conditions as sensed by components of the monitor system. The mathematical model may utilize physical equations and/or characteristic curves provided by, for example, manufacturers of the different devices of the EFC system and may thereby represent the nominal behavior of the EFC system or the components thereof. As discussed below, an actual power consumption of the EFC system may be measured and compared with the power consumption estimated by the model. As further discussed below, in case of discrepancies, an alert may be generated by the algorithm to notify the abnormal behavior.

According to one or more examples, the outputting the total estimated electrical power consumption 103 may include outputting from one component of a control system, for example from a model of a supervisory-level controller to an anomaly detector of a supervisory-level controller. Alternately, according to one or more examples, the outputting the total estimated electrical power consumption may include outputting to an output unit.

According to one or more examples, the comparing the total estimated electrical power consumption to actual power consumption 104 may include obtaining an actual total power consumption of the EFC system and comparing the total estimated electrical power consumption to the actual total power consumption of the EFC system, for example, by a controller or an element of a controller as described herein.

Thus, according to one or more examples, the monitoring method, for example, the monitoring algorithm thereof, may monitor the electrical power consumption data recorded by an energy meter of the monitor system and detect deviations of the measured data from the expected electrical power consumption.

According to one or more examples, a difference between the total estimated electrical power consumption and the actual power consumption may be compared to a threshold 105. The threshold may be a percentage of the actual power consumption, for example 5%, a percentage of the total estimated electrical power consumption, for example, 5%, or may be a non-variable threshold, as would be understood by one of skill in the art.

According to one or more examples, if the difference between the total estimated electrical power consumption and the actual power consumption is not greater than the threshold, the method may proceed, repeating operations 101-105, iteratively or continuously. If the difference between the total estimated electrical power consumption and the actual power consumption is greater than the threshold, the method may include outputting a signal 106, and may also include repeating operations 101-105, iteratively or continuously.

According to one or more examples, the outputting the signal 106 may include controlling an output unit to output one or more of an alert and data by means of, for example, a display or a speaker, as would be understood by one of skill in the art. The signal may be an alert and/or notification. According to an example implementation, the signal may be a control signal to one or more elements of the cooling system, thereby effecting a shut-down of one or more elements of the cooling system or a change in the status of one or more elements of the cooling system.

According to one or more examples, there may be multiple thresholds. For example, the determination of whether a difference between the estimated power consumption and the actual power consumption exceeds a threshold 105 may include comparing the difference to multiple thresholds, and the output of the signal may be based on which of multiple thresholds is exceeded. For example, the determination of whether the difference exceeds a threshold may include comparing the difference to a first threshold and a second threshold, higher than the first threshold. The determination may additionally comprise comparing the difference to one or more additional thresholds. Thus, based on the difference exceeding a first threshold, the signal output may comprise a first signal, for example an alert. Based on the difference exceeding a second threshold, higher than the second threshold, the signal output may comprise a control signal configured to lower a cooling capacity of the system, to alter the operating parameters of one or more elements of the system, or to shut down one or more elements of the system. According to an example implementation, the signal output may be a control signal configured to move a cooling load of the system to one or more external units.

According to one or more examples, the monitoring method and, for example the algorithm thereof, may detect abnormal operation of the EFC system as a whole or one or more components thereof to facilitate correction of inefficiencies before they cause components failure or degradation of performance.

According to one or more examples described herein, estimation of power consumption of one or more components of the EFC system based on sensed conditions, and the comparison of this estimated power consumption to actual power consumption of the one or more components may facilitate identification of an abnormal behavior of one or more components of the system, may facilitate automatic detection of malfunctions without human intervention, and may facilitate early troubleshooting and correction of such abnormal behavior, any one or more of which may facilitate limiting downtime of the EFC system and efficient power consumption.

While examples and implementation of examples have been shown and described herein, it will be understood by those skilled in the art that various changes in form and details may be made therein. For example, various communication protocols can be deployed with various electronic sensors, and/or various visual and/or audio user interfaces can be implemented to facilitate processing and/or displaying information and/or controlling hardware and/or software components of the system.

It may be understood that the examples described herein may be considered in a descriptive sense only and not for purposes of limitation. Descriptions of features or examples within each example may be considered as available for other similar features or examples in other examples.

While examples and implementation of examples have been shown and described herein, it will be understood by those skilled in the art that various changes in form and details may be made therein. For example, various communication protocols can be deployed with various electronic sensors, and/or various visual and/or audio user interfaces can be implemented to facilitate processing and/or displaying information and/or controlling hardware and/or software components of the system.

It may be understood that examples described herein may be considered in a descriptive sense only and not for purposes of limitation. Descriptions of features, examples, or implementations within each example may be considered as available for other similar features, examples, or implementations in other examples.

While examples have been and described with reference to the figures, it will be understood by those skilled in the art that various changes in form and details may be made therein without departing from the scope as defined by the following claims.

Further examples are set out in the clauses below:
1. An cooling system comprising:
   a heat exchanger and a unit, comprising at least one of a pump and a fan, configured to pump a coolant through the heat exchanger;
   a monitor system comprising: a sensor unit configured to sense a physical condition of the cooling system and an electrical power meter configured to sense an actual power consumption of the cooling system; and
   a control system, communicatively coupled to the monitor system, the control system comprising: a memory storing instructions thereon and a processor configured to execute the instructions and thereby:
      receive, from the monitor system, data of the physical condition and the actual power consumption of the cooling system;
      calculate an estimated power consumption of the cooling system based on the data of the physical condition;
      compare the estimated power consumption of the cooling system to the actual power consumption of the cooling system;
      determine whether a difference between the estimated power consumption of the cooling system and the actual power consumption of the cooling system is greater than a threshold; and
      based on the actual power consumption exceeding the threshold, outputting a control signal.
2. The cooling system of clause 1, wherein the outputting the control signal comprises outputting an alert.
3. The cooling system of clause 1 or clause 2, wherein the outputting the control signal comprises controlling the cooling system to change from a normal operation mode to an irregular operation mode.
4. The cooling system of clause 3, wherein controlling the cooling system to change from a normal operation mode to an irregular operation mode comprises one of lowering a cooling capacity of the cooling system and shutting down the cooling system.
5. The cooling system of any one of clauses 1 to 4, wherein:
   the cooling system is an evaporative free cooling (EFC) system, the coolant is air, at least one of a pump and a fan comprises a first fan unit configured to direct return air into the heat exchanger and supply air out of the heat exchanger, and a second fan unit configured to direct ambient air into the heat exchanger and exhaust air out of the heat exchanger; and
   the sensor unit comprises: a return air temperature sensor configured to sense a temperature of the return air directed into the heat exchanger; an ambient air temperature sensor configured to sense a temperature of the ambient air; a first fan sensor configured to sense a speed of the first fan unit; a second fan sensor configured to sense a speed of the second fan unit; and
   the data of the physical condition comprises the temperature of the return air, the temperature of the ambient air, the speed of the first fan unit, and the speed of the second fan unit.
6. The EFC combination system of clause 5, wherein:
   the EFC system further comprises an evaporative system comprising a pump configured to pump water from a water tank to a sprinkler unit configured to spray water onto the heat exchanger;
   the monitor system further comprises a sensor configured to sense a pump status; and
   the data of the physical condition further comprises the pump status.
7. The combination system of clause 5 or clause 6, wherein:
   the EFC system further comprises a direct expansion system comprising an evaporator and a compressor;
   the monitor system further comprises at least one compressor sensor configured to sense a compressor status and a compressor speed; and
   the data of the physical condition further comprises the compressor status and the compressor speed.
8. The cooling system of any one of clauses 1 to 7, further comprising:
   a user interface comprising at least one of a display unit and a speaker;
   wherein the processor of the control system is configured to control the user interface to output one of a visual display and an alert sound.
9. A monitoring and diagnostic system of a cooling system, the monitoring and diagnostic system comprising:
   a monitor system comprising: a sensor unit configured to sense a physical condition of the cooling system and an electrical power meter configured to sense an actual power consumption of the cooling system; and
   a control system, communicatively coupled to the monitor system, the control system comprising a memory storing instructions thereon and a processor configured to execute the instructions and thereby:
      receive, from the monitor system, data of the physical condition and the actual power consumption of the cooling system;
      calculate an estimated power consumption of the cooling system based on the data of the physical condition;
      compare the estimated power consumption of the cooling system to the actual power consumption of the cooling system;
      determine whether a difference between the estimated power consumption of the cooling system and the actual power consumption of the cooling system is greater than a threshold; and
      based on the actual power consumption of the cooling system exceeding the threshold, outputting a control signal.
10. The monitoring and diagnostic system of clause 9, wherein the outputting the control signal comprises outputting an alert.
11. The monitoring and diagnostic system of clause 9 or clause 10, wherein the outputting the control signal comprises controlling the cooling system to change from a normal operation mode to an irregular operation mode.
12. The monitoring and diagnostic system of clause 11, wherein controlling the cooling system to change from a normal operation mode to an irregular operation mode comprises one of lowering a cooling capacity of the cooling system and shutting down the cooling system.
13. The monitoring and diagnostic system of any one of clauses 9 to 12, wherein:
   the sensor unit comprises: a return air temperature sensor configured to sense a temperature of return air directed into a heat exchanger of the cooling system; an ambient air temperature sensor configured to sense a temperature of ambient air; a first fan sensor configured to sense a speed of a first fan unit of the cooling system; and a second fan sensor configured to sense a speed of a second fan unit of the cooling system; and
   the data of the physical condition comprises the temperature of the return air, the temperature of the ambient air, the speed of the first fan unit, and the speed of the second fan unit.
14. The monitoring and diagnostic system of any one of clauses 9 to 13, wherein:
   the sensor unit further comprises a sensor configured to sense a status of a pump pumping water from a water tank to a sprinkler unit of the cooling system; and
   the data of the physical condition further comprises the pump status.
15. The monitoring and diagnostic system of any one of clauses 9 to 14, wherein:
   the sensor unit further comprises a compressor sensor configured to sense a compressor status and a compressor speed of a compressor of the cooling system; and
   the data of the physical condition further comprises the compressor status and the compressor speed.
16. The monitoring and diagnostic system of any one of clauses 9 to 15, further comprising:
   a user interface comprising at least one of a display unit and a speaker;
   wherein the processor of the control system is configured to control the user interface to output one of a visual display and an alert sound.
17. An evaporative free cooling (EFC) combination system comprising:
   an EFC system comprising: a heat exchanger, a first fan unit configured to direct warm return air into the heat exchanger and cool supply air out of the heat exchanger, and a second fan unit configured to direct cool ambient air into the heat exchanger and warm exhaust air out of the heat exchanger;
   a monitor system comprising: a sensor unit configured to sense a physical condition of the EFC system and an electrical power meter configured to sense an actual power consumption of the EFC system; and
   a control system, communicatively coupled to the monitor system, the control system comprising a memory storing instructions thereon and a processor configured to execute the instructions and thereby:
      receive, from the monitor system, data of the physical condition and the actual power consumption of the EFC system;
      calculate an estimated power consumption of the EFC system based on the data of the physical condition;
      compare the estimated power consumption of the EFC system to the actual power consumption of the EFC system;
      determine whether a difference between the estimated power consumption of the EFC system and the actual power consumption of the EFC system is greater than a threshold; and
      output an alert based on whether the difference between the estimated power consumption of the EFC system and the actual power consumption of the EFC system is greater than the threshold.
18. The combination system of clause 17, wherein:
   the sensor unit comprises: a return air temperature sensor configured to sense a temperature of return air directed into the heat exchanger; an ambient air temperature sensor configured to sense a temperature of ambient air; a first fan sensor configured to sense a speed of the first fan unit; a second fan sensor configured to sense a speed of the second fan unit; and
   the data of the physical condition comprises the temperature of the return air, the temperature of the ambient air, a speed of the first fan unit, and a speed of the second fan unit.
19. The combination system of clause 17 or clause 18, wherein:
   the EFC system further comprises an evaporative system comprising a pump unit configured to pump water from a water tank to a sprinkler unit configured to spray water onto the heat exchanger;
   the monitor system further comprises a sensor configured to sense a pump status; and the data of the physical condition further comprises the pump status.
20. The combination system of any one of clauses 17 to 19, wherein:
   the EFC system further comprises a backup system comprising an evaporator and a compressor;
   the monitor system further comprises a sensor configured to sense a compressor status and a compressor speed; and
   the data of the physical condition further comprises the compressor status and compressor speed.
21. The combination system of any one of clauses 17 to 20, further comprising:
   a user interface comprising at least one of a display unit and a speaker;
   wherein the processor of the control system is configured to control the user interface to output one of a visual display and an alert sound.
22. A monitoring and diagnostic system of an evaporative free cooling (EFC) system, the monitoring and diagnostic system comprising:
   a monitor system comprising: a sensor unit configured to sense a physical condition of the EFC system and an electrical power meter configured to sense an actual power consumption of the EFC system; and
   a control system, communicatively coupled to the monitor system, the control system comprising a memory storing instructions thereon and a processor configured to execute the instructions and thereby:
      receive, from the monitor system, data of the physical condition and the actual power consumption of the EFC system;
      calculate an estimated power consumption of the EFC system based on the data of the physical condition;
      compare the estimated power consumption of the EFC system to the actual power consumption of the EFC system;
      determine whether a difference between the estimated power consumption of the EFC system and the actual power consumption of the EFC system is greater than a threshold; and
      output an alert based on whether the difference between the estimated power consumption of the EFC system and the actual power consumption of the EFC system is greater than the threshold.
23. The monitoring and diagnostic system of clause 22, wherein:
   the sensor unit comprises: a return air temperature sensor configured to sense a temperature of return air directed into a heat exchanger of the EFC system; an ambient air temperature sensor configured to sense a temperature of ambient air; a first fan sensor configured to sense a speed of a first fan unit of the EFC system; and a second fan sensor configured to sense a speed of a second fan unit of the EFC system; and
   the data of the physical condition comprises the temperature of the return air, the temperature of the ambient air, a speed of the first fan unit, and a speed of the second fan unit.
24. The monitoring and diagnostic system of clause 22 or clause 23, further comprising:
   a user interface comprising at least one of a display unit and a speaker;
   wherein the processor of the control system is configured to control the user interface to output one of a visual display and an alert sound.

## Claims

1. A monitoring and diagnostic system of a cooling system, the monitoring and diagnostic system comprising:
a monitor system comprising: a sensor unit configured to sense a physical condition of the cooling system and an electrical power meter configured to sense an actual power consumption of the cooling system; and
a control system, communicatively coupled to the monitor system, the control system comprising: a memory storing instructions thereon and a processor configured to execute the instructions and thereby:
receive, from the monitor system, data of the physical condition and the actual power consumption of the cooling system;
calculate an estimated power consumption of the cooling system based on the data of the physical condition;
compare the estimated power consumption of the cooling system to the actual power consumption of the cooling system;
determine whether a difference between the estimated power consumption of the cooling system and the actual power consumption of the cooling system is greater than a threshold; and
based on the actual power consumption of the cooling system exceeding the threshold, outputting a control signal.

2. The monitoring and diagnostic system of claim 1, wherein the outputting the control signal comprises outputting an alert.

3. The monitoring and diagnostic system of claim 1 or claim 2, wherein the outputting the control signal comprises controlling the cooling system to change from a normal operation mode to an irregular operation mode.

4. The monitoring and diagnostic system of claim 3, wherein controlling the cooling system to change from a normal operation mode to an irregular operation mode comprises one of lowering a cooling capacity of the cooling system and shutting down the cooling system.

5. The monitoring and diagnostic system of any one of claims 1 to 4, wherein:
the sensor unit comprises: a return air temperature sensor configured to sense a temperature of return air directed into a heat exchanger of the cooling system; an ambient air temperature sensor configured to sense a temperature of ambient air; a first fan sensor configured to sense a speed of a first fan unit of the cooling system; and a second fan sensor configured to sense a speed of a second fan unit of the cooling system; and
the data of the physical condition comprises the temperature of the return air, the temperature of the ambient air, the speed of the first fan unit, and the speed of the second fan unit.

6. The monitoring and diagnostic system of any one of claims 1 to 5, wherein:
the sensor unit further comprises a sensor configured to sense a status of a pump pumping water from a water tank to a sprinkler unit of the cooling system; and
the data of the physical condition further comprises the pump status.

7. The monitoring and diagnostic system of any one of claims 1 to 6, wherein:
the sensor unit further comprises a compressor sensor configured to sense a compressor status and a compressor speed of a compressor of the cooling system; and
the data of the physical condition further comprises the compressor status and the compressor speed.

8. The monitoring and diagnostic system of any one of claims 1 to 7, further comprising a user interface comprising at least one of a display unit and a speaker;
wherein the processor of the control system is configured to control the user interface to output one of a visual display and an alert sound.

9. A cooling system comprising:
a heat exchanger and a unit, comprising at least one of a pump and a fan, configured to pump a coolant through the heat exchanger; and
the monitoring and diagnostic system of any one of claims 1 to 8.

10. The cooling system of claim 9, wherein, when the monitoring and diagnostic system is the monitoring and diagnostic system of claim 5, the cooling system is an evaporative free cooling, 'EFC', system, the coolant is air, at least one of a pump and a fan comprises a first fan unit configured to direct return air into the heat exchanger and supply air out of the heat exchanger, and a second fan unit configured to direct ambient air into the heat exchanger and exhaust air out of the heat exchanger.

11. The cooling system of claim 10, wherein, when the monitoring and diagnostic system is the monitoring and diagnostic system of claim 6, the cooling system further comprises an evaporative system comprising the pump configured to pump water from the water tank to the sprinkler unit, wherein the sprinkler unit is configured to spray water onto the heat exchanger.

12. The cooling system of claim 10 or claim 11, wherein, when the monitoring and diagnostic system is the monitoring and diagnostic system of claim 7, the cooling system further comprises a direct expansion system comprising an evaporator and the compressor.
